# EUROPEAN PATENT SPECIFICATION

(11) **EP 4 318 922 B1**
(45) Date of publication and mention of the grant of the patent: **01.10.2025**
(21) Application number: 22784337.2
(22) Date of filing: 15.02.2022
(51) Int. Cl.: H02M 7/48, H01L 25/07, H01L 25/18

(54) **POWER MODULE**
LEISTUNGSMODUL
MODULE DE PUISSANCE

(30) Priority: 06.04.2021 JP 2021064917
(43) Date of publication of application: 07.02.2024
(73) Proprietor: Mitsubishi Heavy Industries, Ltd., Tokyo 100-8332 (JP)
(72) Inventor: EZUMI, Masahiko, Tokyo 100-8332 (JP); NAKAGAMI, Takashi, Tokyo 100-8332 (JP)
(74) Representative: Studio Torta S.p.A.
(86) International application number: PCT/JP2022/005869
(87) International publication number: WO 2022/215352

(56) References cited:
- JP-A- 2006 141 096
- JP-A- 2010 103 372
- JP-A- 2015 023 619
- JP-A- 2016 158 358
- JP-A- 2016 158 358
- JP-A- 2018 022 818
- JP-A- 2020 188 524

## Description

### Technical Field

The present disclosure relates to a power module.

Priority is claimed on Japanese Patent Application No. 2021-064917, filed April 6, 2021.

### Background Art

In power conversion devices such as inverters that drive motors, heat is generated depending on the amount of the current flowing through a power module or the like. Therefore, it is necessary to protect components such as semiconductor elements and capacitors from such generated heat. For example, Patent Document 1 proposes a technique of connecting a connection portion, connecting a switching element and a capacitor, to a cooler via an electrical insulation material and a heat transfer material to suppress heat transferred from the switching element to the capacitor and protect the capacitor from overheating.

Document JP 2018 022818 A discloses a power module in which the output conductor includes a base portion, a first connection portion extending from the base portion, and a second connection portion extending from the base portion to reach the non-circuit pattern section and is connected to the non-circuit pattern section in a thermally conductible manner. The first connection portion does not reach, and is not electrically connected to, the circuit pattern section.

### Citation List

### Patent Document

Patent Document 1: Japanese Unexamined Patent Application, First Publication No. 2017-188998

### Summary of Invention

### Technical Problem

Incidentally, in the power module of the above-described power conversion device, a current sensor may be provided on an output conductor such as an output bus bar in order to monitor an output current. When the current flowing through the power module increases, there is a possibility that the temperature of such an output conductor may exceed the upper limit restriction of the operating temperature range of the current sensor.

On the other hand, when attempting to cool the output conductor of the power module with such a cooling structure described in Patent Document 1, it is necessary to provide a cooling structure separate from the cooler for the power module. As a result, a problem arises in that the power conversion device increases in size.

The present disclosure has been made to solve the above-described problems and an object thereof is to provide a power module capable of cooling an output conductor while suppressing an increase in size of a power conversion device.

### Solution to Problem

In order to solve the above-described problems, a power module according to the present disclosure includes: an input conductor; a power semiconductor element which is configured to convert a current input from the input conductor; a substrate on which the power semiconductor element is mounted; and an output conductor which is configured to output the current converted by the power semiconductor element, wherein the substrate includes a circuit pattern section which is provided with a circuit pattern electrically connected to the power semiconductor element and a non-circuit pattern section which is electrically insulated from the circuit pattern section, and wherein the output conductor includes a base portion, a first connection portion extending from the base portion to reach the circuit pattern section and is electrically connected to the circuit pattern section, and a second connection portion extending from the base portion to reach the non-circuit pattern section and is connected to the non-circuit pattern section in a thermally conductible manner.

### Advantageous Effects of Invention

According to the present disclosure, it is possible to provide a power module capable of cooling an output terminal while suppressing an increase in size of a power conversion device.

### Brief Description of Drawings

FIG. 1 is a perspective view of a power module according to a first embodiment of the present disclosure.
FIG. 2 is a perspective view of a power module according to a second embodiment of the present disclosure.
FIG. 3 is a cross-sectional view taken along a line III-III in FIG. 2 when viewed diagonally from above.

### Description of Embodiments

### First Embodiment

### (Power module)

Hereinafter, a power module according to a first embodiment of the present disclosure will be described with reference to the drawings.

The power module of this embodiment constitutes, for example, a part of a power conversion circuit included in a power conversion device such as an inverter or a converter. Additionally, as the power module of this embodiment, an example of a case in which the power module constitutes an inverter that converts an input DC current into an AC current and outputs the AC current will be described.

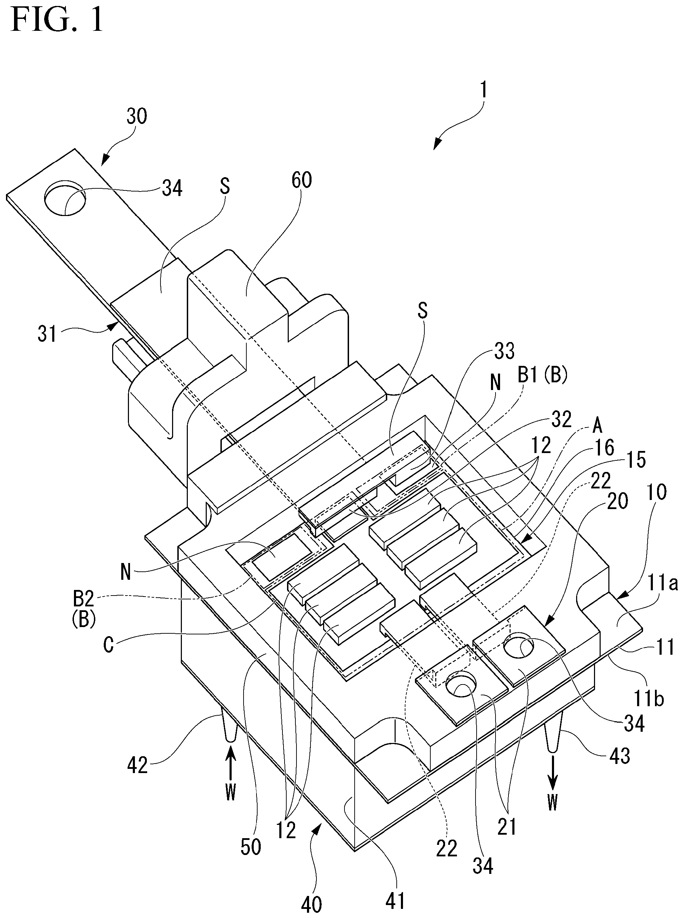

FIG. 1 is a perspective view of the power module according to the first embodiment.

As shown in FIG. 1, a power module 1 of this embodiment includes a base plate 10, an input conductor 20, a power semiconductor element 12, a cooler 40, an output conductor 30, a heat radiation sheet S, a current sensor 60, and a casing 50.

### (Base plate)

The base plate 10 includes a base plate body 11 and a substrate 15.

The base plate body 11 is a flat member. The base plate body 11 of this embodiment is formed of, for example, metal such as copper. The base plate body 11 includes a first surface 11a and a second surface 11b located on the back side of the first surface 11a. That is, the first surface 11a and the second surface 11b of the base plate body 11 are back-to-back. In the following description, the direction in which the base plate body 11 extends will be referred to as the in-plane direction.

The substrate 15 includes a substrate body 16, a circuit pattern section A, and a non-circuit pattern section B.

The substrate body 16 is a flat member. The substrate body 16 is formed of, for example, an insulating material such as ceramic. The substrate body 16 has a front surface and a back surface located on the back side of the front surface and the back surface of the substrate body 16 is bonded to the first surface 11a of the base plate body 11 via a bonding material or the like (not shown). Additionally, as the insulating material forming the substrate body 16, paper phenol, paper epoxy, glass composite, glass epoxy, glass polyimide, fluororesin, and the like can also be adopted.

The circuit pattern section A is a region provided with a circuit pattern C in the substrate body 16. The circuit pattern C is formed on the front surface or the like of the substrate body 16. More specifically, the circuit pattern C is formed of metal such as copper foil and is integrally formed with the substrate body 16 on the front surface or the like of the substrate body 16.

The circuit pattern C formed in the circuit pattern section A includes an input circuit pattern (not shown), an output circuit pattern (not shown), and a control circuit pattern (not shown). The input circuit pattern is a circuit pattern provided to input a current to the power semiconductor element 12 to be described later. The output circuit pattern is a circuit pattern provided to output a current converted by the power semiconductor element 12. The control circuit pattern is a circuit pattern provided to connect a control unit (not shown) that generates a control signal for controlling the power semiconductor element 12.

The non-circuit pattern section B is electrically insulated and provided independently from the circuit pattern section A. This non-circuit pattern section B is a region not provided with the circuit pattern section A in the substrate body 16. That is, the non-circuit pattern section B is not provided with the circuit pattern C. The non-circuit pattern section B includes a connection pattern section N provided on the front surface of the substrate body 16. This connection pattern section N is electrically insulated from the circuit pattern C formed in the circuit pattern section A.

The connection pattern section N of this embodiment is a rectangular pattern formed of metal foil such as copper. More specifically, the connection pattern section N is formed on the front surface of the substrate body 16 and is integrally formed with the substrate body 16. Here, two non-circuit pattern sections B of this embodiment are provided to be separated from each other in the in-plane direction in the front surface of the substrate body 16. Hereinafter, these two non-circuit pattern sections B will be respectively referred to as a first non-circuit pattern section B1 and a second non-circuit pattern section B2.

### (Input conductor)

The input conductor 20 is a conductor that receives a current input from a current supply source (not shown) provided outside the power module 1 via a capacitor or the like (not shown). The input conductor 20 includes an input terminal 21 and an input connection portion 22.

The input terminal 21 is a flat member having a rectangular shape in plan view. A fastening hole 34 is formed at the center portion of the input terminal 21. In this embodiment, two input terminals 21 are arranged side by side. An end portion of an input bus bar (not shown) which is a current input conductor is fastened to each of these two input terminals 21 by a bolt, so that the input terminal 21 is electrically connected to the input bus bar.

The input connection portion 22 electrically connects the input terminal 21 and the circuit pattern C. That is, the input connection portion 22 guides a current flowing to the input conductor 20 toward the circuit pattern C. The current flowing to this circuit pattern C is distributed to the plurality of power semiconductor elements 12 provided on the circuit pattern C. The input terminal 21 and the input connection portion 22 of this embodiment are formed of, for example, metal such as copper and extend from the input terminal 21 toward the circuit pattern section A.

### (Power semiconductor element)

The power semiconductor element 12 is, for example, an IGBT, MOSFET, FWD, or the like and is mounted on the circuit pattern C of the substrate body 16. In this embodiment, a case is exemplified in which six power semiconductor elements 12 are mounted on the side of the first surface 11a of the base plate 10. The power semiconductor element 12 includes an input terminal (not shown), an output terminal (not shown), and a control terminal (not shown).

The input terminal (not shown) is electrically connected to the input circuit of the circuit pattern C via a bonding material or the like. For example, one end of a lead frame (not shown) serving as a conducting wire is electrically connected to the output terminal (not shown). The other end of the lead frame (not shown) is electrically connected to the output circuit pattern (not shown) of the circuit pattern C. A control signal generated by the control unit connected to the control circuit of the circuit pattern C is input to the control terminal (not shown). The power semiconductor element 12 performs switching according to the control signal input via the control terminal (not shown).

### (Cooler)

The cooler 40 cools the circuit pattern section A and the non-circuit pattern section B. The cooler 40 is fixed to the second surface 11b of the base plate body 11 via a bonding material or the like. The cooler 40 includes a cooler casing 41, a refrigerant inlet 42, and a refrigerant outlet 43.

Although not shown in the drawings, the cooler 40 of this embodiment further includes, for example, a cooler base portion and a heat radiation fin. The cooler base portion has, for example, a flat plate shape and includes a bonding surface which is bonded to the second surface 11b of the substrate body 16 via a bonding material or the like and a fin surface which is disposed back-to-back with the bonding surface and is provided with the heat radiation fin. A plurality of the heat radiation fins are provided to extend from the fin surface of the cooler base portion. The heat of the power semiconductor element 12 is conducted to the heat radiation fins (not shown) via the circuit pattern C, the substrate body 16, and the cooler base portion (not shown).

The cooler casing 41 is bonded to the second surface 11b of the base plate 10 via a bonding material or the like. The cooler casing 41 of this embodiment covers the cooler base portion (not shown) and the heat radiation fins (not shown).

The refrigerant inlet 42 is provided in the cooler casing 41 and a refrigerant W supplied from a refrigerant supply device (not shown) provided outside the power module 1 flows thereinto.

The refrigerant outlet 43 is provided in the cooler casing 41 and the refrigerant W flowing from the refrigerant inlet 42 flows out therefrom to be returned to, for example, the refrigerant supply device. In this embodiment, for example, water is adopted as the refrigerant W. Additionally, a liquid other than water may be adopted as the refrigerant W.

The heat radiation fins (not shown) of the cooler 40 are defined by the cooler casing 41 and the base plate 10 and are immersed in a refrigerant flow path (not shown) through which the refrigerant W flows. The heat radiation fins (not shown) always exchange heat with the refrigerant W flowing through the refrigerant flow path (not shown). Accordingly, the heat of the power semiconductor element 12 conducted to the heat radiation fins (not shown) via the circuit pattern C, the substrate body 16, and the cooler base portion (not shown) is radiated to the refrigerant W.

For example, solder can be adopted as the bonding material used for bonding the base plate body 11 and the substrate body 16, bonding the power semiconductor element 12 and the circuit pattern C, bonding the substrate body 16 and the cooler base portion, and bonding the base plate body 11 and the cooler casing 41. Additionally, for example, sintered materials (powders of metals, ceramics, and the like) and adhesives can be exemplified as the bonding materials other than solder.

For example, aluminum can be used as the material of the cooler base portion (not shown), the heat radiation fin (not shown), the cooler casing 41, the refrigerant inlet 42, and the refrigerant outlet 43. Additionally, iron, copper, and ceramics can be exemplified as the materials other than aluminum forming the cooler base portion (not shown), the heat radiation fin (not shown), the cooler casing 41, the refrigerant inlet 42, and the refrigerant outlet 43.

### (Output conductor)

The output conductor 30 is a conductor that outputs a current converted by the power semiconductor element 12. The output conductor 30 includes a base portion 31, a first connection portion 32, and a second connection portion 33.

The base portion 31 extends toward the outside of the base plate 10 from a position facing the substrate 15 provided on the first surface 11a of the base plate 10. A current output bus bar is used as the output conductor 30 of this embodiment. The fastening hole 34 is formed at the outer end portion of the base portion 31 of the output conductor 30. For example, an output wiring (not shown) for outputting a current can be fastened to the outer end portion of the base portion 31 by a bolt or the like.

The first connection portion 32 extends from the base portion 31 to reach the circuit pattern section A. The first connection portion 32 of this embodiment extends from the inner end portion on the side opposite to the outer end portion in the base portion 31 to reach the circuit pattern section A. The first connection portion 32 electrically connects the base portion 31 and the circuit pattern C of the circuit pattern section A.

The second connection portion 33 extends from the base portion 31 to reach the non-circuit pattern section B. The second connection portion 33 of this embodiment extends from the inner end portion in the base portion 31 to reach the connection pattern N of the non-circuit pattern section B. The second connection portion 33 connects the base portion 31 and the connection pattern section N of the non-circuit pattern section B so that heat can be conducted therebetween. Further, the second connection portion 33 of this embodiment is connected to the first non-circuit pattern section B1 in two non-circuit pattern sections B. Additionally, the second connection portion 33 may be connected to the second non-circuit pattern section B2.

The base portion 31, the first connection portion 32, and the second connection portion 33 can be integrally formed of, for example, metal such as copper. Additionally, the materials forming the base portion 31, the first connection portion 32, and the second connection portion 33 are not limited to metal such as copper. For example, the base portion 31, the first connection portion 32, and the second connection portion 33 may be formed of materials other than metal as long as they are electrically conductive and thermally conductive.

### (Heat radiation sheet)

The heat radiation sheet S is provided to cover the surfaces of the base portion 31 and the second connection portion 33 of the output conductor 30. The heat radiation sheet S is adhered to the surfaces of the base portion 31 and the second connection portion 33 via, for example, adhesive or the like. The heat radiation sheet S is formed of a material having a higher thermal conductivity than that of the output conductor 30. The heat radiation sheet S can actively conduct heat from a high-temperature position to a low-temperature position.

For example, a graphite sheet which is a heat-conductive material can be adopted as the heat radiation sheet S. By providing such a heat radiation sheet S, heat generated in the base portion 31 can be conducted to the second connection portion 33 instead of the first connection portion 32 and can be actively conducted to the first non-circuit pattern section B1.

### (Current sensor)

The current sensor 60 is a sensor that detects the value of the current flowing through the output conductor 30. The current sensor 60 is provided to surround an outer surface of a part of the base portion 31 of the output conductor 30. In other words, the current sensor 60 is a through-type current sensor such as a current transformer that can measure the value of the current flowing through the base portion 31 of the output conductor 30 without contacting the output conductor 30.

### (Casing)

The casing 50 surrounds the substrate 15, the first connection portion 32, and the second connection portion 33 at least from the outside. In other words, the casing 50 is formed along the outer edge portion of the substrate 15 to surround the substrate 15. The casing 50 is disposed to protrude from the first surface 11a of the base plate body 11. The casing 50 is fixed to the first surface 11a of the base plate body 11 via adhesive or the like. For example, the casing 50 can be formed of an insulating material such as PPS (polyphenylene sulfide) which is a synthetic resin. Additionally, the material forming the casing 50 is not limited to an insulating material.

### (Operation and effect)

The power module 1 according to the first embodiment includes the input conductor 20, the power semiconductor element 12 which converts a current input from the input conductor 20, the base plate 10 on which the power semiconductor element 12 is mounted, and the output conductor 30 which outputs a current converted by the power semiconductor element 12, wherein the base plate 10 includes the circuit pattern section A which is provided with the circuit pattern C electrically connected to the power semiconductor element 12 and the non-circuit pattern section B which is electrically insulated from the circuit pattern section A, and wherein the output conductor 30 includes the base portion 31, the first connection portion 32 which extends from the base portion 31 to reach the circuit pattern section A and is electrically connected to the circuit pattern section A, and the second connection portion 33 which extends from the base portion 31 to reach the non-circuit pattern section B and is connected to the non-circuit pattern section B in a thermally conductible manner.

According to such a configuration, since an output current converted by the power semiconductor element 12 flows through the output conductor 30, heat is generated in the base portion 31 of the output conductor 30 depending on the current amount. However, this heat is conducted from the base portion 31 to the second connection portion 33 in the process of being conducted through the output conductor 30. Then, the heat conducted to the second connection portion 33 is conducted from the second connection portion 33 to the non-circuit pattern section B. That is, the base portion 31 can be indirectly cooled by releasing the heat generated in the base portion 31 to the non-circuit pattern section B. Thus, there is no need to add, for example, a cooler or the like to the output conductor 30. That is, it is possible to cool the output conductor 30 while suppressing an increase in size of the power conversion device.

Further, since it is possible to suppress an increase in temperature of the base portion 31 with the above-described configuration, the temperature of the current sensor 60 can be maintained in the operating temperature range of the current sensor 60, for example, when the current sensor 60 is provided to surround the outer surface of a part of the base portion 31.

Further, the power module 1 according to the first embodiment further includes the heat radiation sheet S which is provided to cover the surfaces of the base portion 31 and the second connection portion 33.

According to such a configuration, the heat generated in the base portion 31 of the output conductor 30 can be actively conducted to the second connection portion 33. Further, the heat of the second connection portion 33 can also be actively conducted to the non-circuit pattern section B. Thus, the heat generated in the base portion 31 can be effectively released to the non-circuit pattern section B. Further, since the heat radiation sheet S covers the surface of the base portion 31, a heat-insulating effect in which heat is not easily radiated from the inside to the outside of the heat radiation sheet S is exhibited. Accordingly, the heat radiation sheet S can mainly retain the heat radiated from the surface of the base portion 31 to the inside between the heat radiation sheet S and the base portion 31. Thus, the amount of heat radiated to the outside from the heat radiation sheet S can be reduced, for example, at the installation position of the current sensor 60.

Further, the power module 1 according to the first embodiment further includes the casing 50 which surrounds the substrate 15, the first connection portion 32, and the second connection portion 33 at least from the outside.

According to such a configuration, since both the first connection portion 32 and the second connection portion 33 are stored inside the casing 50, the base portion 31 can be cooled through the second connection portion 33 without separately providing a cooling structure for cooling the base portion 31 outside the casing 50.

Further, the power module 1 according to the first embodiment further includes the cooler 40 which cools the circuit pattern section A and the non-circuit pattern section B.

According to such a configuration, the non-circuit pattern section B can be cooled by the cooler 40 cooling the circuit pattern section A. Thus, there is no need to separately provide a cooling structure for cooling the non-circuit pattern section B. Then, since the non-circuit pattern section B is cooled by the cooler 40, the second connection portion 33 connected to the non-circuit pattern section B can be cooled. Thus, it is possible to suppress an increase in temperature of the base portion 31 compared to a case in which only the first connection portion 32 is provided.

Further, in the power module 1 according to the first embodiment, the base plate 10 further includes the connection pattern section N formed on the non-circuit pattern section B and the second connection portion 33 is connected to the connection pattern section N.

According to such a configuration, the second connection portion 33 can be easily connected to the non-circuit pattern section B in a thermally conductible manner using, for example, solder as a bonding material.

### Second Embodiment

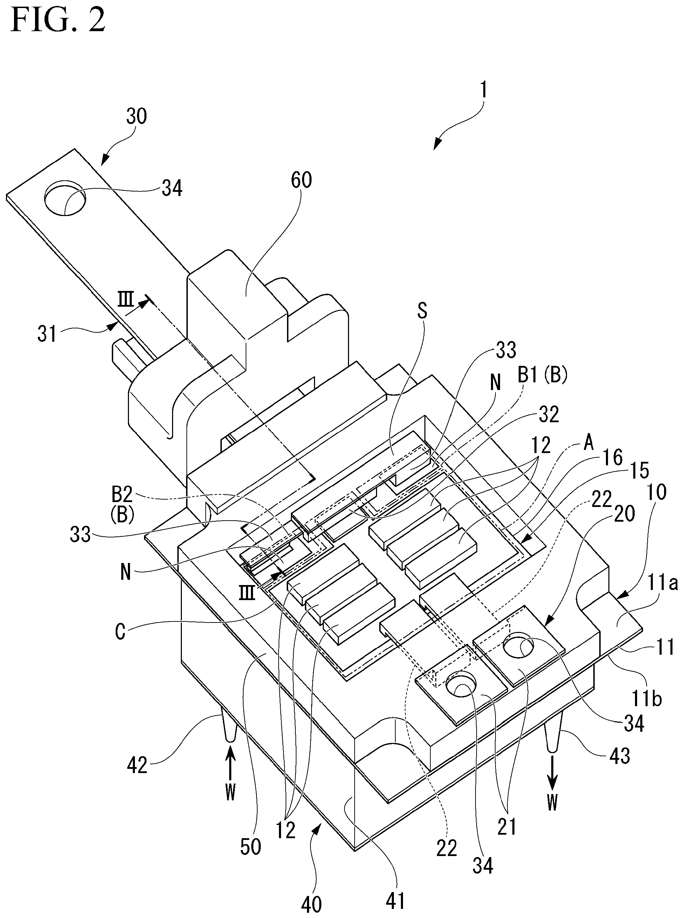

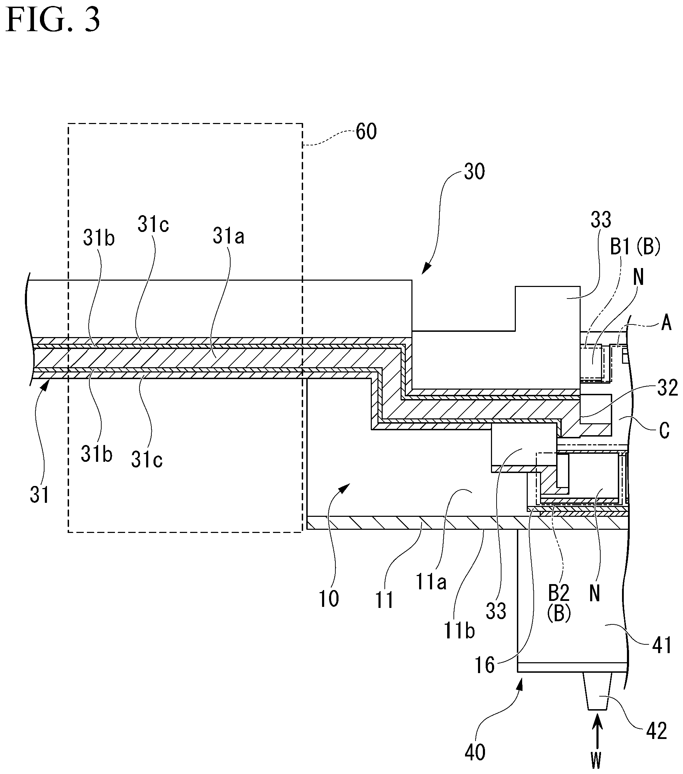

Hereinafter, a power module according to a second embodiment of the present disclosure will be described with reference to FIGS. 2 and 3. In the second embodiment, the configuration of the output conductor 30 provided in the power module 1 of the first embodiment is partially different and the power module of the second embodiment does not include the heat radiation sheet S described in the first embodiment. Components similar to those in the first embodiment are indicated by the same reference numerals and detailed descriptions are omitted.

FIG. 2 is a perspective view of the power module according to the second embodiment. As shown in FIG. 2, the output conductor 30 of the power module 1 of this embodiment includes a plurality of the second connection portions 33. In this embodiment, two second connection portions 33 are provided in the base portion 31. FIG. 3 is a cross-sectional view taken along a line III-III in FIG. 2 when viewed diagonally from above.

### (Output conductor)

The output conductor 30 is a conductor that outputs a current converted by the power semiconductor element 12. Similarly to the first embodiment, the output conductor 30 includes the base portion 31, the first connection portion 32, and the second connection portion 33.

The base portion 31 extends from a position facing the substrate 15 provided in the first surface 11a of the base plate 10 toward the outside of the base plate 10. The base portion 31 includes a base portion body 31a, a heat-insulating layer 31b, and a heat conductive layer 31c.

The base portion body 31a is a conductor and is formed of metal such as copper.

The heat-insulating layer 31b is provided on the outer surface of the base portion body 31a in a layered manner. An insulating material such as polyphenylene sulfide (PPS) which is a synthetic resin can be adopted as the heat-insulating layer 31b. Additionally, an insulating material other than PPS may be adopted for the heat-insulating layer 31b.

The heat-conductive layer 31c is formed of metal such as copper and is provided in a layered manner to cover the heat-insulating layer 31b.

The first connection portion 32 extends from the base portion body 31a of the base portion 31 to reach the circuit pattern section A. The first connection portion 32 electrically connects the base portion body 31a and the circuit pattern C of the circuit pattern section A.

The second connection portion 33 extends from the heat-conductive layer 31c of the base portion 31 to reach the non-circuit pattern section B. The second connection portion 33 connects the heat-conductive layer 31c and the non-circuit pattern section B in a thermally conductible manner. More specifically, the second connection portion 33 is connected to the connection pattern section N of the non-circuit pattern section B.

In this embodiment, two second connection portions 33 extend from the heat-conductive layer 31c. These two second connection portions 33 are respectively connected to the connection pattern section N of the first non-circuit pattern section B1 and the connection pattern section N of the second non-circuit pattern section B2. Two of the second connection portions 33 sandwich the base portion body 31a and the heat-insulating layer 31b, one (the upper heat conductive layer 31c in the cross-section of FIG. 3) is connected to the first non-circuit pattern section B1, and the other (the lower heat-conductive layer 31c in the cross-section of FIG. 3) is connected to the second non-circuit pattern section B2.

In this embodiment, for example, metal such as copper can be adopted for the base portion body 31a, the heat-conductive layer 31c, the first connection portion 32, and the second connection portion 33.

### (Operation and effect)

In the power module 1 according to the second embodiment, the base portion 31 includes the base portion body 31a, the heat-insulating layer 31b which is provided in the outer surface of the base portion body 31a, and the heat-conductive layer 31c which covers the heat-insulating layer 31b and the second connection portion 33 extends from the heat-conductive layer 31c.

According to such a configuration, since the heat-insulating layer 31b is provided on the surface of the base portion body 31a, the heat-insulating layer 31b mainly retains the heat radiated from the surface of the base portion body 31a to the inside between the heat-insulating layer 31b and the base portion body 31a. Thus, the amount of heat radiated to the outside from the heat-insulating layer 31b can be reduced. Then, the heat-conductive layer 31c conducts the heat conducted from the base portion body 31a through the heat-insulating layer 31b to the second connection portion 33. The heat conducted to the second connection portion 33 is finally conducted to the non-circuit pattern section B. That is, the base portion body 31a can be cooled by releasing the heat of the base portion body 31a to the non-circuit pattern section B.

Further, in the power module 1 according to the second embodiment, a plurality of the second connection portions 33 extend from the base portion 31.

According to such a configuration, the heat generated in the base portion 31 can be more effectively released to the non-circuit pattern section B.

### Other Embodiments

Although the embodiments of the present disclosure have been described in detail with reference to the drawings, the detailed configuration is not limited to the configuration of each embodiment, and additions, omissions, substitutions, and other changes to the configuration can be made without departing from the invention, which is defined by the appended claims.

In the first embodiment, the second connection portion 33 is connected to the first non-circuit pattern section B1 or the second non-circuit pattern section B2, but it may be connected to both non-circuit pattern sections B. Accordingly, more heat generated in the base portion 31 can be released to the non-circuit pattern section B.

Further, in the embodiment, although the power module 1 has been described for use in a power conversion circuit of an inverter, the present disclosure is not limited to the power conversion circuit of the inverter. The semiconductor device may constitute a part of a power conversion circuit of a converter that inputs an AC current and outputs a DC current, a booster circuit of a regulator that changes the magnitude of the voltage of the DC current, or the like.

### Appendix

The power module described in the above embodiment is understood, for example, as below.
(1) The power module 1 according to a first aspect includes: the input conductor 20; the power semiconductor element 12 which is configured to convert a current input from the input conductor 20; the substrate 15 on which the power semiconductor element 12 is mounted; and the output conductor 30 which is configured to output the current converted by the power semiconductor element 12, wherein the substrate 15 includes the circuit pattern section A which is provided with the circuit pattern C electrically connected to the power semiconductor element 12 and the non-circuit pattern section B which is electrically insulated from the circuit pattern section A, and wherein the output conductor 30 includes the base portion 31, the first connection portion 32 extending from the end portion of the base portion 31 to reach the circuit pattern section A and is electrically connected to the circuit pattern section A, and the second connection portion 33 extending from the base portion 31 to reach the non-circuit pattern section and is connected to the non-circuit pattern section B in a thermally conductible manner.
   According to such a configuration, an output current converted by the power semiconductor element 12 flows through the output conductor 30 so that heat is generated in the base portion 31 of the output conductor 30 depending on the current amount. However, this heat is conducted from the base portion 31 to the second connection portion 33 in the process of being conducted through the output conductor 30. Then, the heat conducted to the second connection portion 33 is conducted from the second connection portion 33 to the non-circuit pattern section B. That is, the base portion 31 can be cooled by releasing the heat generated in the base portion 31 to the non-circuit pattern section B. Thus, there is no need to add, for example, a cooler or the like to the output conductor 30. That is, it is possible to cool the output conductor 30 while suppressing an increase in size of the power conversion device. Further, according to the above-described configuration, since it is possible to suppress an increase in temperature of the base portion 31, the temperature of the current sensor 60 can be maintained in the operating temperature range of the current sensor 60, for example, when the current sensor 60 is provided to surround the outer surface of a part of the base portion 31.
(2) The power module 1 according to a second aspect is the power module 1 of (1) may further include the heat radiation sheet S which is provided to cover the surfaces of the base portion 31 and the second connection portion 33.
   According to such a configuration, the heat generated in the base portion 31 of the output conductor 30 can be actively conducted to the second connection portion 33. Further, the heat of the second connection portion 33 can also be actively conducted to the non-circuit pattern section B. Thus, the heat generated in the base portion 31 can be effectively released to the non-circuit pattern section B. Further, since the heat radiation sheet S covers the surface of the base portion 31, a heat-insulating effect in which heat is not easily radiated from the inside to the outside of the heat radiation sheet S is exhibited. Accordingly, the heat radiation sheet S can mainly retain the heat radiated from the surface of the base portion 31 to the inside between the heat radiation sheet S and the base portion 31. Thus, the amount of heat radiated to the outside from the heat radiation sheet S can be reduced.
(3) The power module 1 according to a third aspect is the power module 1 of (1), wherein the base portion 31 may include the base portion body 31a, the heat-insulating layer 31b which is provided on the outer surface of the base portion body 31a, and the heat conductive layer 31c covering the heat-insulating layer 31b, and wherein the second connection portion 33 may be extended from the heat-conductive layer 31c.
   According to such a configuration, since the heat-insulating layer 31b is provided on the surface of the base portion body 31a, the heat-insulating layer 31b mainly retains the heat radiated from the surface of the base portion body 31a to the inside between the heat-insulating layer 31b and the base portion body 31a. Thus, the amount of heat radiated to the outside from the heat-insulating layer 31b can be reduced. Then, the heat conductive-layer 31c conducts the heat conducted from the base portion body 31a through the heat-insulating layer 31b to the second connection portion 33. The heat conducted to the second connection portion 33 is finally conducted to the non-circuit pattern section B. That is, the base portion body 31a can be cooled by releasing the heat of the base portion body 31a to the non-circuit pattern section B.
(4) The power module 1 according to a fourth aspect is the power module 1 of any one of (1) to (3), wherein a plurality of the second connection portions 33 may be extended from the base portion 31.
   According to such a configuration, the heat generated in the base portion 31 can be more effectively released to the non-circuit pattern section B.
(5) The power module 1 according to a fifth aspect is the power module 1 of any one of (1) to (4) may further include the casing 50 surrounding the substrate 15, the first connection portion 32, and the second connection portion 33 at least from the outside thereof.
   According to such a configuration, since both the first connection portion 32 and the second connection portion 33 are stored inside the casing 50, the base portion 31 can be cooled through the second connection portion 33 without separately providing a cooling structure for cooling the base portion 31 outside the casing 50.
(6) The power module 1 according to a sixth aspect is the power module 1 of any one of (1) to (5) may further include the cooler 40 which is configured to cool the circuit pattern section A and the non-circuit pattern section B.
   According to such a configuration, the non-circuit pattern section B can be cooled by the cooler 40 cooling the circuit pattern section A. Thus, there is no need to separately provide a cooling structure for cooling the non-circuit pattern section B. Then, since the non-circuit pattern section B is cooled by the cooler 40, the second connection portion 33 connected to the non-circuit pattern section B can be cooled. Thus, it is possible to suppress an increase in temperature of the base portion 31 compared to a case in which only the first connection portion 32 is provided.
(7) The power module 1 according to a seventh aspect is the power module 1 of any one of (1) to (6), wherein the substrate 15 may further include the connection pattern section N formed on the non-circuit pattern section B, and wherein the second connection portion 33 may be connected to the connection pattern section N.

According to such a configuration, the second connection portion 33 can be easily connected to the non-circuit pattern section B in a thermally conductible manner using, for example, solder as a bonding material.

### Industrial Applicability

According to the present disclosure, it is possible to provide a power module capable of cooling an output terminal while suppressing an increase in size of a power conversion device.

### Reference Signs List

1 Power module
10 Base plate
11 Base plate body
11a First surface
11b Second surface
12 Power semiconductor element
15 Substrate
16 Substrate body
20 Input conductor
21 Input terminal
22 Input connection portion
30 Output conductor
31 Base portion
31a Base portion body
31b Heat-insulating layer
31c Heat-conductive layer
32 First connection portion
33 Second connection portion
34 Fastening hole
40 Cooler
41 Cooler casing
42 Refrigerant inlet
43 Refrigerant outlet
50 Casing
60 Current sensor
A Circuit pattern section
B Non-circuit pattern section
B1 First non-circuit pattern section
B2 Second non-circuit pattern section
C Circuit pattern
G Heat radiation sheet
N Connection pattern section
W Refrigerant

## Claims

1. A power module comprising:
an input conductor (20);
a power semiconductor element (12) which is configured to convert a current input from the input conductor;
a substrate (15) on which the power semiconductor element is mounted; and
an output conductor (30) which is configured to output the current converted by the power semiconductor element,
wherein the substrate includes a circuit pattern section (A) which is provided with a circuit pattern (C) electrically connected to the power semiconductor element and a non-circuit pattern section (B) which is electrically insulated from the circuit pattern section, and
wherein the output conductor includes a base portion (31), a first connection portion (32) extending from the base portion to reach the circuit pattern section and being of electrically connected to the circuit pattern section, and a second connection portion (33) extending from the base portion to reach the non-circuit pattern section and is connected to the non-circuit pattern section in a thermally conductible manner.

2. The power module according to claim 1, further comprising:
a heat radiation sheet which is provided to cover surfaces of the base portion and the second connection portion.

3. The power module according to claim 1,
wherein the base portion includes a base portion body, a heat-insulating layer which is provided on an outer surface of the base portion body, and a heat-conductive layer covering the heat-insulating layer, and
wherein the second connection portion is extended from the heat-conductive layer.

4. The power module according to any one of claims 1 to 3,
wherein a plurality of the second connection portions are extended from the base portion.

5. The power module according to any one of claims 1 to 4, further comprising:
a casing surrounding the substrate, the first connection portion, and the second connection portion at least from an outside thereof.

6. The power module according to any one of claims 1 to 5, further comprising:
a cooler which is configured to cool the circuit pattern section and the non-circuit pattern section.

7. The power module according to any one of claims 1 to 6,
wherein the substrate further includes a connection pattern section formed in the non-circuit pattern section, and
wherein the second connection portion is connected to the connection pattern section.

## Patentansprüche

1. Leistungsmodul, umfassend:
einen Eingangsleiter (20);
ein Leistungshalbleiterelement (12), das konfiguriert ist, einen Stromeingang bzw. zugeführten Strom von dem Eingangsleiter umzuwandeln;
ein Substrat (15), auf dem das Leistungshalbleiterelement montiert ist; und
einen Ausgangsleiter (30), der konfiguriert ist, den von dem Leistungshalbleiterelement umgewandelten Strom auszugeben,
wobei das Substrat einen Schaltungsmusterbereich (A), der mit einem Schaltungsmuster (C) versehen ist, das elektrisch mit dem Leistungshalbleiterelement verbunden ist, und einen Nicht-Schaltungsmusterbereich (B) enthält, der von dem Schaltungsmusterbereich elektrisch isoliert ist, und
wobei der Ausgangsleiter einen Basisabschnitt (31), einen ersten Verbindungsabschnitt (32), der sich von dem Basisabschnitt erstreckt, um den Schaltungsmusterbereich zu erreichen, und der mit dem Schaltungsmusterbereich elektrisch verbunden ist, und einen zweiten Verbindungsabschnitt (33) enthält, der sich von dem Basisabschnitt erstreckt, um den Nicht-Schaltungsmusterbereich zu erreichen, und der mit dem Nicht-Schaltungsmusterbereich wärmeleitend verbunden ist.

2. Leistungsmodul nach Anspruch 1, ferner umfassend:
eine Wärmeabstrahlplatte, die dahingehend bereitgestellt ist, Flächen bzw. Oberflächen des Basisabschnitts und des zweiten Verbindungsabschnitts zu bedecken.

3. Leistungsmodul nach Anspruch 1,
wobei der Basisabschnitt einen Basisabschnittskörper, eine Wärmeisolierschicht, die auf einer Außenfläche bzw. -oberfläche des Basisabschnittskörpers bereitgestellt ist, und eine Wärmeleitschicht enthält, welche die Wärmeisolierschicht bedeckt, und
wobei der zweite Verbindungsabschnitt von der Wärmeleitschicht erstreckt ist bzw. ausgeht.

4. Leistungsmodul nach einem der Ansprüche 1 bis 3,
wobei eine Mehrzahl der zweiten Verbindungsabschnitte von dem Basisabschnitt erstreckt ist bzw. ausgeht.

5. Leistungsmodul nach einem der Ansprüche 1 bis 4, ferner umfassend:
ein Gehäuse, welches das Substrat, den ersten Verbindungsabschnitt und den zweiten Verbindungsabschnitt zumindest von deren Außenseite umgibt.

6. Leistungsmodul nach einem der Ansprüche 1 bis 5, ferner umfassend:
einen Kühler, der konfiguriert ist, den Schaltungsmusterbereich und den Nicht-Schaltungsmusterbereich zu kühlen.

7. Leistungsmodul nach einem der Ansprüche 1 bis 6,
wobei das Substrat ferner einen Verbindungsmusterabschnitt enthält, der in dem Nicht-Schaltungsmusterbereich ausgebildet ist, und
wobei der zweite Verbindungsabschnitt mit dem Verbindungsmusterabschnitt verbunden ist.

## Revendications

1. Module de puissance comprenant :
un conducteur d'entrée (20) ;
un élément semi-conducteur de puissance (12)
qui est configuré pour convertir une entrée de courant provenant du conducteur d'entrée ;
un substrat (15) sur lequel est monté l'élément semi-conducteur de puissance ; et
un conducteur de sortie (30) qui est configuré pour délivrer en sortie le courant converti par l'élément semi-conducteur de puissance,
dans lequel le substrat comporte une section de motif de circuit (A) qui est pourvue d'un motif de circuit (C) connecté électriquement à l'élément semi-conducteur de puissance et une section de non-motif de circuit (B) qui est isolée électriquement de la section de motif de circuit, et
dans lequel le conducteur de sortie comporte une partie de base (31), une première partie de connexion (32) s'étendant à partir de la partie de base pour atteindre la section de motif de circuit et qui est connectée électriquement à la section de motif de circuit, et une seconde partie de connexion (33) s'étendant à partir de la partie de base pour atteindre la section de non-motif de circuit et qui est connectée à la section de non-motif de circuit d'une manière thermoconductrice.

2. Module de puissance selon la revendication 1, comprenant en outre :
une feuille de rayonnement thermique qui est disposée pour recouvrir des surfaces de la partie de base et de la seconde partie de connexion.

3. Module de puissance selon la revendication 1,
dans lequel la partie de base comporte un corps de partie de base, une couche d'isolation thermique qui est disposée sur une surface externe du corps de partie de base, et une couche de conduction thermique recouvrant la couche d'isolation thermique, et
dans lequel la seconde partie de connexion est étendue à partir de la couche de conduction thermique.

4. Module de puissance selon l'une quelconque des revendications 1 à 3,
dans lequel une pluralité de secondes parties de connexion sont étendues à partir de la partie de base.

5. Module de puissance selon l'une quelconque des revendications 1 à 4, comprenant en outre :
un boîtier entourant le substrat, la première partie de connexion, et la seconde partie de connexion au moins par rapport à un extérieur de ceux-ci.

6. Module de puissance selon l'une quelconque des revendications 1 à 5, comprenant en outre :
un refroidisseur qui est configuré pour refroidir la section de motif de circuit et la section de non-motif de circuit.

7. Module de puissance selon l'une quelconque des revendications 1 à 6,
dans lequel le substrat comporte en outre une section de motif de connexion formée dans la section de non-motif de circuit, et
dans lequel la seconde partie de connexion est connectée à la section de motif de connexion.
